(19) **Europäisches Patentamt** / **European Patent Office** / **Office européen des brevets**

(11) **EP 4 449 054 B1**

(12) **FASCICULE DE BREVET EUROPEEN**

(45) Date de publication et mention de la délivrance du brevet:
**11.06.2025 Bulletin 2025/24**

(21) Numéro de dépôt: **22850643.2**

(22) Date de dépôt: **17.12.2022**

(51) Classification Internationale des Brevets (IPC):
**G01B 7/16** (2006.01)   **G01L 1/20** (2006.01)
**G06F 3/041** (2006.01)   **G06F 3/045** (2006.01)
**H03K 17/96** (2006.01)

(52) Classification Coopérative des Brevets (CPC):
**G01L 1/20; G01B 7/18; G01L 1/205; H03K 17/9647**

(86) Numéro de dépôt international:
**PCT/EP2022/086523**

(87) Numéro de publication internationale:
**WO 2023/111344 (22.06.2023 Gazette 2023/25)**

(54) **MICROCAPTEUR À ÉLECTRODES INTERDIGITÉES**

**MIKROSENSOR MIT INEINANDERGREIFENDEN ELEKTRODEN**

**MICROSENSOR WITH INTERDIGITATED ELECTRODES**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **17.12.2021 FR 2113933**

(43) Date de publication de la demande:
**23.10.2024 Bulletin 2024/43**

(73) Titulaire: **Nanomade Lab**
**31400 Toulouse (FR)**

(72) Inventeur: **SEVERAC, Fabrice**
**31300 TOULOUSE (FR)**

(74) Mandataire: **Hamann, Jean-Christophe**
**H&I Partners France**
**25, Allée Cavalière**
**44500 La Baule (FR)**

(56) Documents cités:
**EP-A1- 1 113 252     WO-A1-2014/016429**

- GRÄBNER DANIEL ET AL: "Screen-Printed Resistive Pressure Sensors: Influence of Electrode Geometry on the Performance and on Cross-Sensitivity to Strain and Temperature", vol. 1837, no. 1, 1 March 2021 (2021-03-01), GB, pages 012004, XP055934861, ISSN: 1742-6588, Retrieved from the Internet <URL:https://iopscience.iop.org/article/10.1088/1742-6596/1837/1/012004/pdf> DOI: 10.1088/1742-6596/1837/1/012004
- RIVADENEYRA ALMUDENA ET AL: "A novel electrode structure compared with interdigitated electrodes as capacitive sensor", SENSORS AND ACTUATORS B: CHEMICAL, ELSEVIER BV, NL, vol. 204, 12 August 2014 (2014-08-12), pages 552 - 560, XP029070125, ISSN: 0925-4005, DOI: 10.1016/J.SNB.2014.08.010

## Description

L'invention concerne un microcapteur mettant en œuvre une ou plusieurs assemblées de nanoparticules connectées électriquement à des électrodes interdigitées.

## Domaine technique

L'invention appartient au domaine des microcapteurs ultrasensibles aptes à mesurer une grandeur physique, notamment une force ou une pression sur une surface fonctionnalisée, notamment, mais non exclusivement, sur une surface tactile transparente telle qu'un écran de tablette ou de téléphone intelligent.

## Technique antérieure

Le document WO2014/016429 décrit une surface tactile transparente pourvue d'une pluralité de microjauges, aptes à mesurer une pression appliquée sur ladite surface et déposées selon une matrice sur ladite surface.

Chacune des microjauges comprend une première et une deuxième électrode en forme de peigne, chaque peigne comprenant une pluralité de dents rectilignes connectées en une de leurs extrémités par une barrette, lesdites électrodes étant juxtaposées en symétrie miroir, de sorte que les dents de chaque peigne soient interdigitées entre les dents de l'autre peigne.

Des assemblées de nanoparticules conductrices ou semi-conductrices dans un ligand isolant sont intercalées entre chaque paire de dents, l'une des dents de la paire appartenant à la première électrode et l'autre à la deuxième électrode.

Chaque ensemble comprenant une dent de chaque électrode et une assemblée de nanoparticules, constitue une microjauge de déformation ou de contrainte, de sorte que si chaque électrode en peigne comprend N dents, le capteur résultant comprend 2N-1 microjauges.

Ce type de capteur est notamment réalisé et déposé sur une surface par des techniques de lithographie douce.

La multiplication des dents de peigne permet avantageusement, pour un capteur couvrant une surface donnée, de réduire la résistance électrique dudit capteur en comparaison d'un capteur mettant en œuvre une assemblée de nanoparticules de même surface mais n'utilisant que deux électrodes, une à chaque extrémité de l'assemblée de nanoparticule.

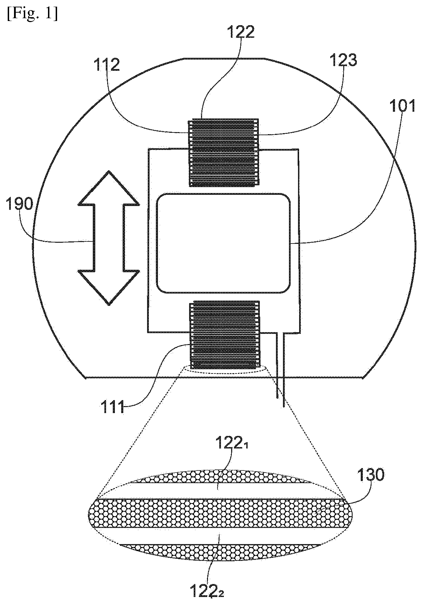

La [Fig.1] montre un exemple d'application d'un capteur de ce type autour d'un « puits de lumière » (101) réalisant sur une surface tactile un bouton renvoyant un retour lumineux, par exemple un pictogramme, sur la zone ou l'action (appui) est réalisée.

Selon cet exemple de réalisation, deux capteurs (111, 112), montés en série et comportant des électrodes en peigne interdigitées, sont placés de part et d'autre dudit puits de lumière (101).

Chaque électrode de chaque capteur comprend une pluralité de pistes (122) rectilignes, les pistes d'une même électrode étant connectées entre elles à une de leurs extrémités par des barrettes (123).

Sur une vue de détail, des assemblées de nanoparticules (130) sont placées entre chaque paire de pistes interdigitées ($122_1$, $122_2$).

Cette solution technique est fonctionnelle mais engendre une perte de sensibilité du fait de la mise en série des deux capteurs, et surtout sa réponse vis-à-vis d'une action de toucher est différente si la pression de toucher est appliquée au centre, dans le puits de lumière (101), sur un des capteurs, ou sur les côtés, sachant que la zone d'appui varie d'un utilisateur à l'autre et même pour un même utilisateur.

De plus, le type de capteur utilisé, compte tenu de la position des assemblées de nanoparticules (130) est plus sensible aux sollicitations (190) perpendiculaires aux électrodes ($122_1$, $122_2$)

Aussi si une action quelconque est déclenchée en réponse à l'atteinte d'un seuil de pression mesuré par un tel dispositif, il est nécessaire de tenir compte de ces différences de résultat selon la localisation du toucher, ce qui est susceptible de conduire à une certaine perte de fiabilité.

## Résumé de l'invention

L'invention vise à résoudre les insuffisances exposées ci-avant et concerne à cette fin un microcapteur comprenant une première et une deuxième électrode, chaque électrode comprenant une pluralité de pistes parallèles, chaque piste comprenant une extrémité connectée et une extrémité libre, chaque piste s'étendant depuis une barrette, ladite barrette connectant les pistes par leurs extrémités connectées, les pistes des deux électrodes étant décalées et en symétrie miroir de sorte que lesdites pistes des deux électrodes soient interdigitées et comprennent entre chaque paire de pistes interdigitées une assemblée de nanoparticules dans un ligand, dans lequel chaque piste comprend au moins un changement de direction dans son extension depuis la barrette.

Ainsi, le capteur est adaptable à tout type de contour.

L'invention est avantageusement mise en œuvre selon les modes de réalisation et variantes exposés ci-après, lesquels sont à considérer individuellement ou selon toute combinaison techniquement opérante.

Selon un mode de réalisation avantageux, la pluralité de pistes de chaque électrode comprend des pistes s'étendant depuis la barrette dans des directions opposées. Ce mode de réalisation permet une couverture plus dense de la surface de mesure.

Selon un mode de réalisation, les pistes suivent un contour autour d'une forme centrale. Ce mode de réalisation est notamment adapté à l'installation d'un tel capteur autour d'un puits de lumière.

Avantageusement, les pistes s'étendent depuis la barrette selon une trajectoire angulaire couvrant 270°. Ce mode de réalisation permet de réaliser un capteur ponctuel présentant une uniformité de sensibilité selon toutes les directions dans le plan du capteur.

Selon un mode de réalisation avantageux, les électrodes sont constituées d'oxyde d'indium dopé à l'étain ITO et les assemblées de nanoparticules sont constituées d'ITO dans un ligand à base d'acide phosphonique. Ce mode de réalisation permet de réaliser un microcapteur transparent.

L'invention concerne également une surface tactile comprenant un substrat comportant une zone sensible au toucher laquelle zone comprend un microcapteur selon l'invention, déposé sur ledit substrat.

Selon un mode de réalisation la zone sensible au toucher comprend un puits de lumière et le microcapteur est disposé autour du puits de lumière.

Selon une première variante le substrat est constitué d'un poly(téréphtalate) d'éthylène. Ce mode de réalisation permet de créer une surface tactile souple.

Selon une deuxième variante, le substrat est constitué de dioxyde de silicium, ce mode de réalisation permet la réalisation d'une surface tactile rigide.

Selon une troisième variante, le substrat est constitué d'un polyimide en film mince. Ce mode de réalisation permet de réaliser une surface tactile ultra-souple apte à être rapporté et à s'adapter à la forme de toute surface en toute matière.

## Brève description des dessins

L'invention est mise en œuvre selon les modes de réalisations préférés exposés ci-après, nullement limitatifs, et en référence aux figures 1 à X dans lesquelles :

[Fig.1] relative à l'art antérieur, représente en vue de dessus un exemple de réalisation d'un capteur autour d'un puits de lumière ;

[Fig.2] montre en vue de dessus un exemple de réalisation d'un capteur selon l'invention, installé autour d'un puits de lumière rectangulaire ;

[Fig.3] représente en vue de dessus un exemple de réalisation d'un microcapteur circulaire selon l'invention, les deux pistes représentées séparément puis imbriquées l'une dans l'autre telles qu'elles se présentent sur le capteur ;

[Fig.4] est un exemple de réalisation en vue de dessus, montrant le principe de conception des pistes d'un capteur selon l'invention, les deux pistes représentées séparément puis imbriquées l'une dans l'autre telles qu'elles se présentent sur le capteur ;

[Fig.5] montre selon une vue en perspective et en éclaté un exemple de réalisation d'une surface tactile intégrant un microcapteur selon l'invention

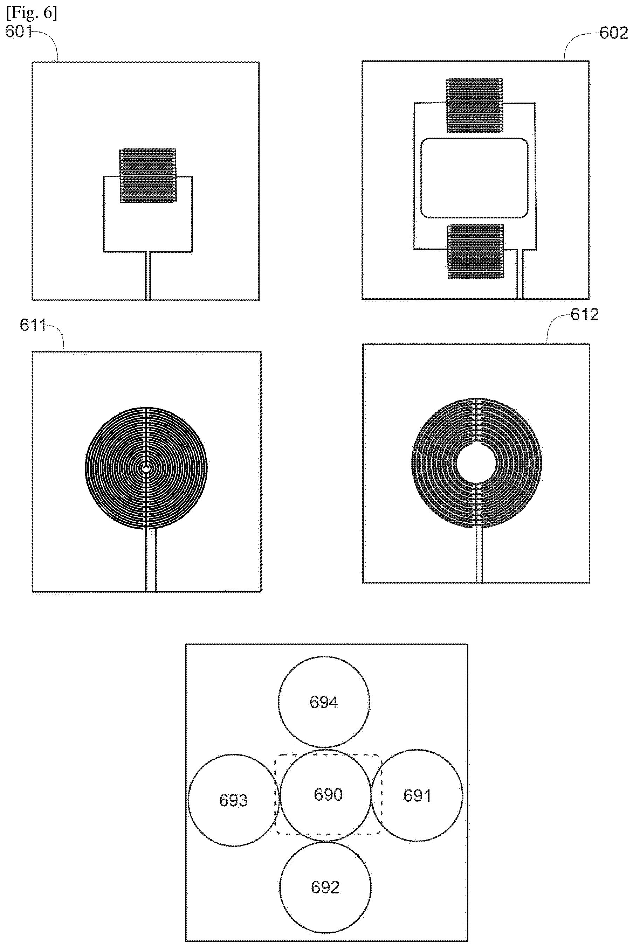

[Fig.6] montre les différentes configurations utilisées pour la réalisation d'un essai.

## Description des modes de réalisation

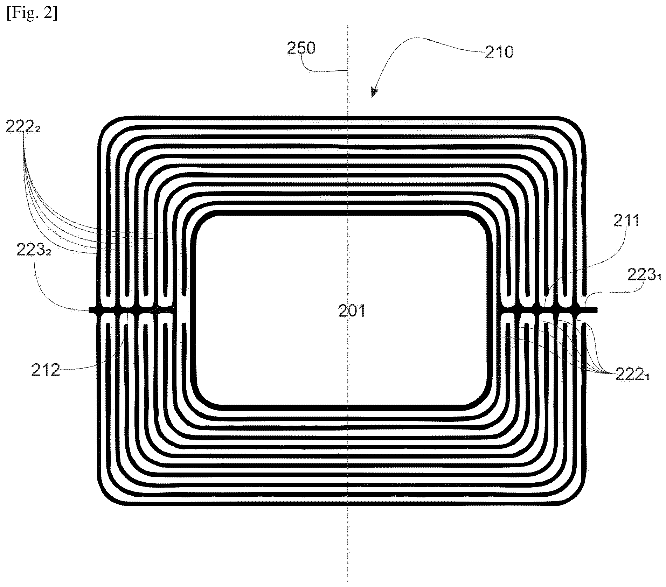

[Fig.2], selon un exemple de réalisation adapté à une fonctionnalisation d'une surface autour d'un puits de lumière (201), le microcapteur (210) objet de l'invention comprend, selon ce mode de réalisation, deux électrodes interdigitées (211, 212) entourant ledit puits de lumière (201).

Chaque électrode comprend une barrette de connexion $(223_1, 223_2)$ reliant les extrémités respectives des pistes $(222_1, 222_2)$ issues desdites barrettes.

Pour chaque électrode (211, 212), les pistes s'étendent depuis la barrette, selon une direction initiale sensiblement perpendiculaire à la barrette. Pour chaque barrette, deux jeux de pistes s'étendent de part et d'autre de ladite barrette $(223_1, 223_2)$ selon des directions opposées.

Chaque électrode est conçue selon le même principe en symétrie miroir par rapport à un axe de symétrie (250) perpendiculaire aux barrettes.

Le microcapteur objet de l'invention est de très faible épaisseur et peut être déposé sur une surface de toute forme.

Les pistes sont constituées d'un matériau électriquement conducteur tel que de l'or, du cuivre ou de l'oxyde d'indium dopé à l'étain, couramment désigné ITO dans le cas où le capteur doit être transparent. Elles sont déposées sur un substrat (non représenté) par des techniques connues de l'art antérieur tel que le dépôt capillaire convectif ou la lithographie douce.

Les mêmes techniques de micro-impression permettent de déposer entre chaque paire de pistes consécutives, l'une des pistes appartenant à la première électrode (211) et l'autre piste appartenant à la seconde électrode (212) une assemblée de nanoparticules conductrices ou semi-conductrices en suspension colloïdale dans un ligand isolant.

À titre d'exemples non limitatifs les nanoparticules sont des nanoparticules d'or, de cuivre, d'oxyde de zinc ou d'ITO, le ligand est par exemple à base d'acide phosphonique.

Lorsqu'une sollicitation est appliquée sur un tel microcapteur soit directement par un appui au moyen du doigt ou d'un stylet sur ledit capteur, soit par une déformation imposée au substrat ou une combinaison de ces modes de sollicitation, la distance entre les nanoparticules est modifiée ce qui modifie les capacités de conduction électrique par effet tunnel entre les nanoparticules en suspension dans le ligand. La mesure de la variation de conductivité ou de résistivité, par l'intermédiaire des électrodes, permet de caractériser cette sollicitation.

Ainsi, chaque assemblée de nanoparticules comprise entre une paire de pistes constitue une microjauge de déformation et le microcapteur intègre une pluralité de microjauges connectée en parallèle, offrant une grande sensibilité et un fort facteur de jauge.

Le facteur de jauge du microcapteur est défini par la variation $\Delta R/R0$ où R0 est la résistance électrique du capteur sans sollicitation et $\Delta R$ la variation de cette résistance électrique lorsque le capteur est soumis à une déformation donnée.

Les microjauges étant connectées en parallèle, celles-ci permettent de réduire la résistance électrique du capteur. Ainsi, la résistance R d'un microcapteur selon l'invention comprenant N microjauges élémentaires de résistance $R_1 ... R_N$ est donnée par :

$$[\text{Math.1}]$$
$$R = \frac{1}{\left(\frac{1}{R_1} + \frac{1}{R_2} + \cdots \frac{1}{R_N}\right)}$$

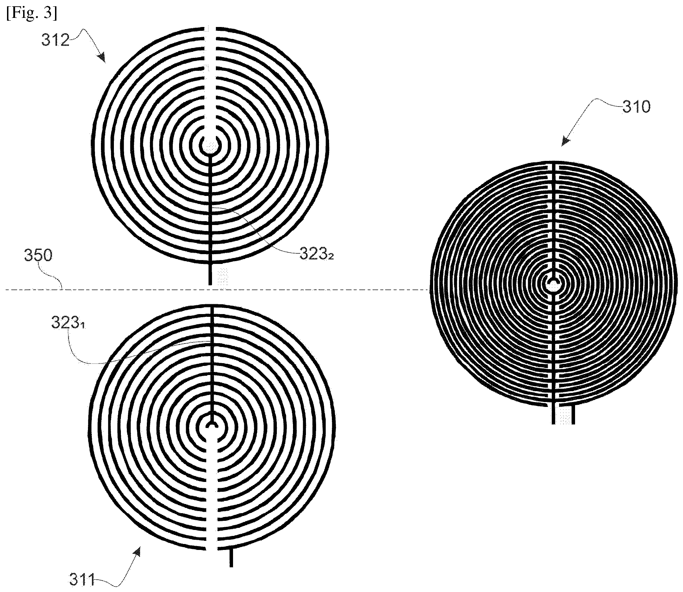

[Fig.3], le microcapteur objet de l'invention n'est pas limité à une forme entourant un puits de lumière. Ainsi, selon cet exemple de réalisation le microcapteur (310) comprend une première électrode (311) comprenant une pluralité de pistes s'étendant sur des trajectoires circulaires de l'ordre de 180° de part et d'autre de la barrette de connexion (323₁) et une seconde électrode (312) de conception similaire en symétrie miroir selon un axe (350) perpendiculaire aux barrettes $(323_1, 323_2)$ des électrodes dont les pistes sont décalées de sorte à pouvoir s'intercaler les unes par rapport aux autres et former le microcapteur (310).

La [Fig.3] représente séparément les deux électrodes (311, 312) du capteur mais l'homme du métier comprend que ces deux électrodes sont directement imprimées, imbriquées / interdigitées l'une dans l'autre.

Des assemblées de nanoparticules (non représentées) sont, de la même manière, déposées entre les paires de pistes se sorte à constituer autant de microjauges élémentaires.

Ainsi le capteur (310) obtenu, couvre pleinement une surface circulaire et présente une sensibilité sensiblement équivalente dans toutes les directions parallèles à la surface du capteur.

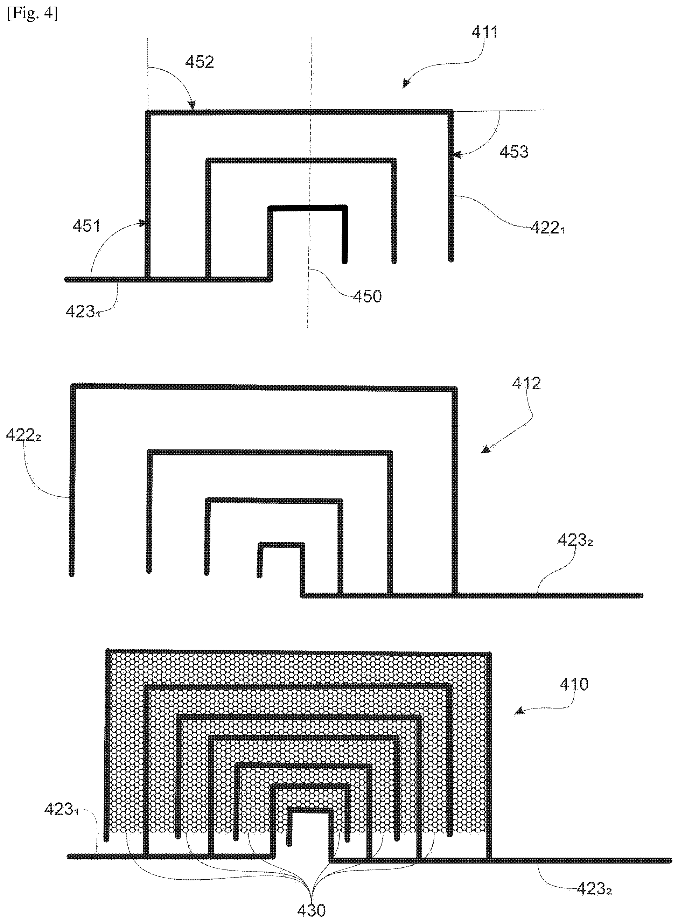

[Fig.4], selon un mode de réalisation, le microcapteur (410) objet de l'invention comprend deux électrodes (411, 412). Chaque électrode comprend une barrette de connexion (423) et au moins une piste $(422_1)$ partant de ladite barrette selon une première direction angulaire (451).

Ladite piste se prolonge en empruntant une trajectoire comprenant au moins une deuxième (452) et une troisième orientation angulaire (453) de sorte que la somme desdites orientations angulaires, partant de la barrette soit sensiblement égale à 270° afin que l'extrémité libre de la piste soit, en orientation, sensiblement perpendiculaire à la barrette $(423_1)$.

La deuxième électrode (412) est sensiblement en symétrie miroir avec la première (411) selon un axe (450) perpendiculaire à la barrette $(423_2)$ et comprend au moins une piste $(422_2)$ décalée par rapport à la piste $(422_1)$ de la première électrode, de sorte à créer un espace de largeur sensiblement constante entre les deux pistes. Espace dans lequel sont déposées des assemblées de nanoparticules (430) de sorte à constituer des microjauges,

Selon cet exemple de réalisation, les pistes comprennent plusieurs portions rectilignes orientées selon des angles (451, 452, 453) les unes par rapport aux autres, l'homme du métier comprend que les mêmes principes s'appliquent pour des pistes de forme circulaire, comme la [Fig.3], elliptique ou composite, comprenant des changements d'orientation progressifs.

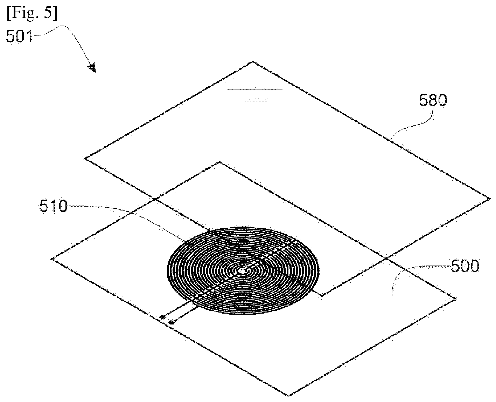

[Fig.5], pour réaliser une surface tactile (501), un ou plusieurs capteurs (510), comprenant chacun 2 électrodes et des assemblées de nanoparticules en suspension colloïdale dans un ligand, sont déposés sur un substrat (500) par des techniques de dépôt capillaire convectif, des techniques de lithographie douce ou des combinaisons de techniques telles que décrites dans le document WO2014/016429.

Selon des modes de réalisation non limitatifs, le substrat est rigide, par exemple constitué de dioxyde de silicium (SiO2) ou flexible, par exemple constitué d'une plaque mince de poly(téréphtalate) d'éthylène (PET) ou souple, par exemple constitué d'un film mince de polyimide.

Avantageusement une couche de passivation (580) est déposée sur l'ensemble afin de le protéger de l'humidité et plus généralement des agressions extérieures.

Ladite couche (580) de passivation est dimensionnée selon la matière la constituant, de sorte qu'elle permette la transmission des contraintes mécaniques aux assemblées de nanoparticules du capteur. À titre d'exemples non limitatifs, la couche de passivation est constituée d'un polyimide, de dioxyde de silicium (SiO2) ou de nitrure de silicium (Si3N4).

Selon un exemple de mise en œuvre la surface tactile déposée sur un substrat souple, tel qu'un film mince de polyimide peut être rapportée, par exemple par collage, sur une surface de toute nature, souple ou rigide, telle que du cuir, du bois, du verre du poly-carbonate, revêtement de sol, ou encore un textile, de sorte à fonctionnaliser cette surface hôte et la rendre ainsi sensible au toucher.

## Exemples

Quatre surfaces tactiles (601, 602, 611, 612) comprenant des microcapteurs sont préparées par micro-impression de pistes en cuivre sur un substrat en polyimide. Ils sont ensuite rapportés, sur des lames de verre de dimensions 76x25x1 mm par collage avec une colle de type cyanolite.

Les premières surfaces tactiles (601, 602) comprennent un microcapteur rectangulaire de 4x4 mm, respectivement sans (601) et avec (602) puits de lumière, réalisé selon une conception de l'art antérieur, comprenant des pistes rectilignes en peigne imbriquées et comprenant au total 20 électrodes de 100 micromètres de largeur et espacées de 100 micromètres. La résistance électrique d'un tel capteur est d'environ 5000 ohms.

Le second ensemble de surfaces tactiles (611, 612) utilise le même substrat sur lequel sont déposés par micro-impression des microcapteurs conçus selon les principes de l'invention, respectivement sans (611) et avec (612) puits de lumières avec des pistes en cuivre.

Le premier (611) des capteurs (611, 612) de ce deuxième ensemble de surfaces tactiles est un capteur circulaire de diamètre 20 mm comprenant 44 électrodes, d'une largeur de 100 micromètres et espacées de 100 micromètres. Le deuxième capteur (612) a les mêmes caractéristiques que le premier (611) mais comporte un puits de lumière sensiblement circulaire de 5 mm de diamètre en son centre.

Pour chacune des lames, une force de même intensité est appliquée au moyen d'un stylet successivement sur 5 points d'application (690, 691, 692, 693, 694).

Pour chaque application de cette force, la variation de résistance du capteur est mesurée et prise égale à 1 lorsque la force est appliquée au centre (690).

Les résultats sont donnés dans le tableau suivant :

[Tab 1]

| Capteur | Position | | | | |
|---|---|---|---|---|---|
| | 690 | 691 | 692 | 693 | 694 |
| 601 | 1 | 0.6899 | 0.776 | 0.6107 | 0.7194 |
| 602 | 1 | 0.9012 | 0.9012 | 0.8047 | 0.8221 |
| 611 | 1 | 0.9641 | 1.012 | 0.8643 | 0.9242 |
| 612 | 1 | 1.0069 | 1.0152 | 1.0014 | 1.0193 |

Les résultats ci-dessus montrent que le microcapteur objet de l'invention produit des résultats plus homogènes et moins sensibles à la position relative de l'appui par rapport au capteur, particulièrement lorsque le capteur est associé à un puits de lumière

Les résultats et les exemples de réalisation présentés ci-avant montrent que l'invention atteint le but visé et que les principes de conception du microcapteur objet de l'invention permettent d'obtenir un capteur de forte sensibilité apte à fonctionnaliser toute surface pour la rendre tactile, seul ou en combinaison avec plusieurs capteurs de cette nature, et reste performant lorsque les zones de toucher sont associées à des puits de lumière.

**Revendications**

1. Microcapteur (210, 310, 410) comprenant une première (211, 311, 411) et une deuxième (212, 312, 412) électrodes, chaque électrode comprenant une pluralité de pistes parallèles (222, 322, 422), chaque piste comprenant une extrémité connectée et une extrémité libre, chaque piste s'étendant depuis une barrette (223, 323, 423), ladite barrette connectant les pistes par leurs extrémités connectées, les pistes des deux électrodes étant décalées et en symétrie miroir de sorte que lesdites pistes des deux électrodes soient interdigitées et comprennent entre chaque paire de pistes interdigitées une assemblée de nanoparticules (430) dans un ligand, **caractérisé en ce que** chaque piste (222, 322, 422) comprend au moins un changement de direction dans son extension depuis la barrette (223, 323, 423).

2. Microcapteur selon la revendication 1, dans lequel la pluralité de pistes de chaque électrode comprend des pistes (222, 322) s'étendant depuis la barrette dans des directions opposées.

3. Microcapteur (210) selon la revendication 1, dans lequel les pistes (222) suivent un contour autour d'une forme centrale (201).

4. Microcapteur selon la revendication 1, dans lequel les pistes (222, 322, 422) s'étendent depuis la barrette selon une trajectoire angulaire couvrant 270°.

5. Microcapteur selon la revendication 1, dans lequel les électrodes (211, 212, 311, 312, 411. 412) sont constituées d'oxyde d'indium dopé à l'étain ITO et les assemblées de nanoparticules sont constituées d'ITO dans un ligand à base d'acide phosphonique.

6. Surface tactile (501, 601, 602, 611, 612) comprenant un substrat (500) comportant une zone sensible au toucher **caractérisée en ce que** ladite zone comprend un microcapteur selon la revendication 1 déposé sur le substrat (500).

7. Surface tactile (612) selon la revendication 6, dans laquelle la zone sensible au toucher comprend un puits de lumière, le microcapteur étant disposé autour du puits de lumière.

8. Surface tactile selon la revendication 6, dans laquelle le substrat (500) est constitué d'un poly(téréphtalate) d'éthylène.

9. Surface tactile selon la revendication 6, dans laquelle le substrat (500) est constitué de dioxyde de silicium.

10. Surface tactile selon la revendication 6, dans laquelle le substrat (500) est constitué d'un polyimide en film mince.

**Patentansprüche**

1. Mikrosensor (210, 310, 410) mit einer ersten Elektrode (211, 311, 411) und einer zweiten Elektrode (212, 312, 412), wobei jede Elektrode eine Vielzahl von parallelen Spuren (222, 322, 422) aufweist, wobei jede Spur ein verbundenes Ende und ein freies Ende aufweist, wobei sich jede Spur von einem Streifen (223, 323, 423) erstreckt, wobei der Streifen die Spuren an ihren verbundenen Enden verbindet, die Spuren der beiden Elektroden versetzt und spiegelsymmetrisch sind, so dass die Spuren der beiden Elektroden ineinandergreifen und zwischen jedem Paar ineinandergreifender Spuren eine Anordnung von Nanopartikeln (430) in einem Liganden umfassen, wobei jede Spur (222, 322, 422), die sich von dem Streifen (223, 323, 423) aus erstreckt, mindestens eine Richtungsänderung aufweist.

2. Mikrosensor nach Anspruch 1, wobei die Vielzahl von Spuren jeder Elektrode Spuren (222, 322) umfasst, die sich von dem Streifen in entgegengesetzte Richtungen erstrecken.

3. Mikrosensor (210) nach Anspruch 1, wobei die Spuren (222) einer Kontur um eine zentrale Form (201) folgen.

4. Mikrosensor nach Anspruch 1, wobei sich die Spuren (222, 322, 422) von dem Streifen entlang einer 270° umfassenden Winkeltrajektorie erstrecken.

5. Mikrosensor nach Anspruch 1, wobei die Elektroden (211, 212, 311, 312, 411, 412) aus zinndotiertem Indiumoxid (ITO) und die Nanopartikelanordnungen aus ITO in einem Phosphonsäure-Liganden hergestellt sind.

6. Berührungsempfindliche Oberfläche (501, 601, 602, 611, 612), die ein Substrat (500) mit einem berührungsempfindlichen Bereich umfasst, **dadurch gekennzeichnet, dass** der Bereich einen auf dem Substrat (500) aufgebrachten Mikrosensor nach Anspruch 1 umfasst.

7. Berührungsempfindliche Oberfläche (612) nach Anspruch 6, wobei der berührungsempfindliche Bereich einen Lichtschacht umfasst und der Mikrosensor um den Lichtschacht herum angeordnet ist.

8. Berührungsempfindliche Oberfläche nach Anspruch 6, wobei das Substrat (500) aus einem Ethylenpoly(terephthalat) hergestellt ist.

9. Berührungsempfindliche Oberfläche nach Anspruch 6, wobei das Substrat (500) aus Siliziumdioxid besteht.

10. Berührungsempfindliche Oberfläche nach Anspruch 6, wobei das Substrat (500) aus einem dünnen Polyimidfilm hergestellt ist

**Claims**

1. A microsensor (210, 310, 410) comprising a first electrode (211, 311,411) and a second electrode (212, 312, 412), each electrode comprising a plurality of parallel tracks (222, 322, 422), each track comprising a connected end and a free end, each track extending from a strip (223, 323, 423), the strip connecting the tracks at their connected ends, the tracks of the two electrodes being offset and in mirror symmetry so that the tracks of the two electrodes are interdigitated and comprise between each pair of interdigitated tracks an assembly of nanoparticles (430) in a ligand, wherein each track (222, 322, 422) extending from the strip (223, 323, 423) comprises at least one change of direction.

2. The microsensor of claim 1, wherein the plurality of tracks of each electrode comprises tracks (222, 322) extending from the strip in opposite directions.

3. The microsensor (210) of claim 1, wherein the tracks (222) follow a contour around a central shape (201).

4. The microsensor of claim 1, wherein the tracks (222, 322, 422) extend from the strip along an angular trajectory covering 270°.

5. The microsensor of claim 1, wherein the electrodes (211, 212, 311, 312,411. 412) are made of tin doped indium oxide (ITO) and the nanoparticle assemblies are made of ITO in a phosphonic acid ligand.

6. A touch-sensitive surface (501, 601, 602, 611, 612) comprising a substrate (500) having a touch-sensitive area **characterized in that** said area comprises a microsensor according to claim 1 deposited on the substrate (500).

7. The touch-sensitive surface (612) of claim 6, wherein the touch sensitive area comprises a light shaft, the microsensor being arranged around the light shaft.

8. The touch-sensitive surface of claim 6, wherein the substrate (500) is made of an ethylene poly(terephthalate).

9. The touch-sensitive surface of claim 6, wherein the substrate (500) is made of silicon dioxide.

10. The touch-sensitive surface of claim 6, wherein the substrate (500) is made of a thin polyimide film

[Fig. 1]

[Fig. 2]

[Fig. 3]

[Fig. 4]

[Fig. 5]

[Fig. 6]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014016429 A